# EUROPEAN PATENT SPECIFICATION

(11) **EP 0 247 714 B1**
(45) Date of publication and mention of the grant of the patent: **05.01.1994**
(21) Application number: 87302981.3
(22) Date of filing: 06.04.1987
(51) Int. Cl.: H01L 21/027, C23C 16/16, C23C 16/48, H01L 21/285, H01L 21/3205

(54) **Method and apparatus for forming a film on a substrate**
Vorrichtung und Verfahren zur Herstellung einer Schicht auf einem Substrat
Méthode et dispositif pour former une couche sur un substrat

(30) Priority: 29.05.1986 JP 124146/86
(43) Date of publication of application: 02.12.1987
(73) Proprietor: SEIKO INSTRUMENTS INC., Tokyo 136 (JP)
(72) Inventor: Kaito, Takashi, Koto-ku Tokyo (JP); Adachi, Tatsuya, Koto-ku Tokyo (JP)
(74) Representative: Miller, Joseph

(56) References cited:
- EP-A- 0 097 819
- EP-A- 0 130 398
- JOURNAL OF APPLIED PHYSICS, vol. 35, no. 7, July 1964, page 2272, New York, US; O.G. FRITZ, Jr.: "Conducting film formed by electron bombardment of tungsten hexacarbonyl vapor in vacuum"
- PATENT ABSTRACTS OF JAPAN, vol. 10, no. 245 (C-368)[2301], 22nd August 1986; & JP-A-61 76 679
- PATENT ABSTRACTS OF JAPAN, vol. 9, no. 244 (E-346)[1967], 30th September 1985; & JP-A-60 94 728
- APPLIED PHYSICS LETTERS, vol. 38, no. 7, 1st April 1981, pages 572-574, American Institute of Physics, New York, US; R. SOLANKI et al.: "Laser photodeposition of refractory metals"

## Description

The present invention relates to a method and apparatus for forming a film on a substrate and,although the invention is not so restricted, it relates more particularly to the additional forming of a metallic patterned film on a semiconductor device for wiring or for the formation of such a film on an exposure photomask (and X-ray mask) for light shielding. The method may be used to change wiring or to detect defective wiring on a device or to repair defects or change patterns on a photomask.

There is disclosed in "Semiconductor World" (January 1986, pages 97-100, by M. Yamamoto) a process and apparatus for repairing a photomask by using a converging ion beam. The process and apparatus form a carbon film which is used as a light-shielding film of an optical lithography mask. The ion beam is also used to form a metallic patterned film. The result of an investigation in this field is reported in "The 17th Symposium on Ion implantation and Submicron Fabrication" by D. Takehara et al., March 1986, pages 153-156. According to this report, the converging ion beam is replaced by a broad rare gas ion beam, and WF₆ or Ta(OC₂H₅)₅ is used as a source gas, whereby a film of W or Ta is formed. The thus formed film, however, contains such a large amount of oxygen and has such a high specific resistance of about 1 Ω ·cm that it is not suitable for wiring.

The prior art is capable of maskless deposition with an ion beam, but is not capable of forming a fine metallic patterned film suitable for adding wiring to a semiconductor device or for repairing defects in a metal pattern for an X-ray mask.

In the Journal of Applied Physics Vol. 35, No. 7, July 1964, page 2272 there is disclosed a method of forming a film on a substrate comprising directing tungsten hexacarbonyl vapour onto a surface of the substrate while the temperature of the latter varies by no more than a few degrees from room temperature, and at the same time irradiating the surface with an electron beam.

It is also known from the Patent Abstracts of Japan Vol. 10, No. 245 (C-368) [2301] August 22nd 1986 to employ a converged ion beam, as opposed to an electron beam, in the formation of a metallic film. Moreover, in Patent Abstracts of Japan Vol. 9, No. 244 (E-346) [1967] September 30, 1985 it is proposed to employ a beam of charged particles in a process for depositing material onto a defective portion of a mask. Additionally in EP-A-0,097,819 a method is proposed for depositing a refractory metal onto a substrate wherein a carbonyl compound vapour of the metal is photodecomposed by ultraviolet radiation of wavelengths less than 200 nm.

According, therefore, to the present invention, there is provided a method of forming a film on a substrate comprising directing a metal hexacarbonyl vapour onto a surface of the substrate and irradiating said surface with a beam, said surface being maintained at a temperature not substantially exceeding 25°C, whereby a metal film is formed on said surface, characterized in that the beam is an ion beam consisting of Ga ions, Au ions, Bi ions, or Pb ions.

The metal hexacarbonyl vapour may be of W (CO)₆, Mo (CO)₆, or Cr (CO)₆.

The ion beam is preferably scanned over the said surface a predetermined number of times.

The ion beam may be derived from a fused metal ion source.

The invention also comprises an apparatus for forming a metal film on a substrate comprising: a support for supporting a substrate; material directing means for directing metal hexacarbonyl vapour onto a surface of said substrate mounted on said support; irradiating means for irradiating said surface with an ion beam consisting of Ga ions, Au ions, Bi ions, or Pb ions; cooling means being provided for maintaining said surface at a temperature not substantially exceeding 25°C.

The irradiating means may comprise an ion beam generator having a fused metal ion source from which the ion beam is drawn out.

A focusing lens system is preferably provided to converge the ion beam which has been drawn out from the ion source.

There may be a blanking electrode which is operable to permit and prevent the ion beam from being directed onto the said surface.

Scanning means are preferably provided for deflecting the ion beam so as to scan it over a predetermined portio of the substrate.

The said support preferably comprises an X-Y stage for moving the substrate in X and Y directions.

The material directing means may comprise a gas source to hold and heat vapourisable material, and a gas gun to blow gas from the gas source onto the said surface.

Preferably, there is a detector arranged to detect secondary charged particles generated by the irradiation of the said surface by the ion beam.

In its preferred form, the apparatus of the present invention comprises a converging ion beam generator, a deflecting electrode to deflect the converging ion beam for scanning, an X-Y stage on which is placed a substrate to be irradiated with the converging ion beam, a gas gun to blow a vapour of metal hexacarbonyl against the substrate locally in the vicinity of the area irradiated with the converging ion beam, and means to cool the substrate.

The source gas of the gas gun may be heated to +40 to +60°C.

The apparatus described above may function in the following manner. The gas gun effectively blows a metal hexacarbonyl vapour against the substrate locally in an area or in the vicinity of the area irradiated with the ion beam. The metal hexacarbonyl vapour is absorbed on the substrate surface because the substrate is cooled by the cooling means. The substrate surface which has absorbed the metal hexacarbonyl vapour is then irradiated with the converging ion beam which is generated by the converging ion beam generator and is converged and controlled for scanning by a deflection electrode, a scanning controller, and a scanning area setting device. While the metal hexacarbonyl vapour is blown continuously, the scanning of the substrate by the converging ion beam is repeated. This process forms a metallic patterned film on the substrate having a film thickness proportional to the number of scans effected.

The method of the invention is thus suitable to provide a fine metallic pattern on a substrate for an X-ray mask or a semiconductor device.

The invention is illustrated, merely by way of example, in the accompanying drawings, in which:-
Figure 1 is a schematic diagram illustrating an apparatus for forming a metallic patterned film according to the present invention, and
Figure 2 is a diagram showing a converging ion beam generator which forms part of the apparatus of Figure 1.

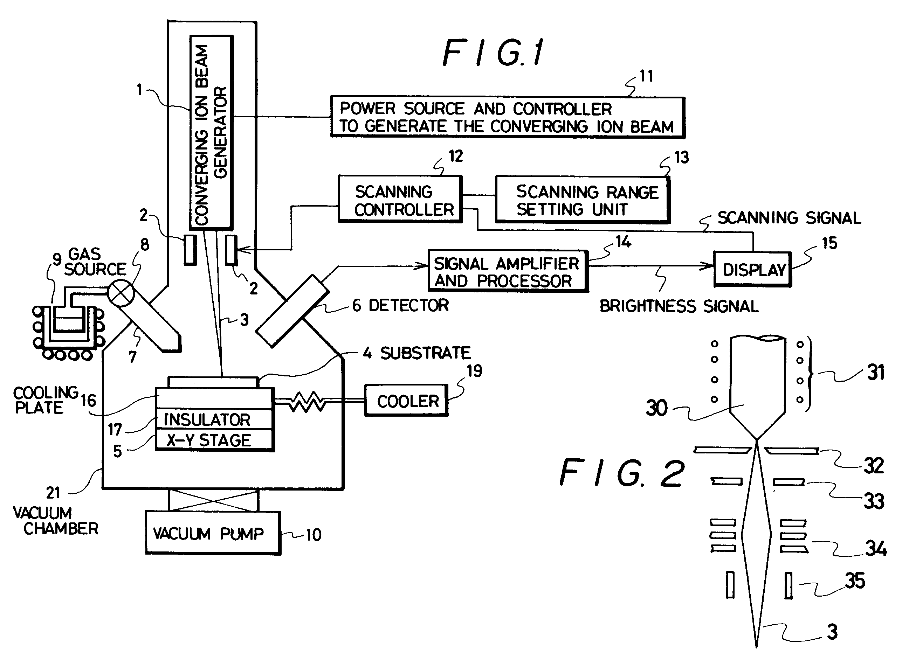

A converging ion beam generator 1 is shown in Figure 2. A substance 30 (Figure 2) to be ionized is Ga metal, the substance 30 being surrounded by a heater 31 to heat and fuse the surface only of the substance 30. The fused Ga metal is drawn out by a drawing electrode 32 so that it is converted into Ga ions. The Ga ions are further heated by a heating electrode 33. The heated Ga ions are converged into an ion beam 3 by a converging lens system 34. The ion beam 3, which is thrown onto a substrate 4, may be turned on and off by a blanking electrode 35. The converging ion beam generator 1 is disposed in a vacuum chamber 21 connected to a vacuum pump 10.

The ion beam 3 generated and controlled as mentioned above is directed onto the substrate 4 which is placed on a cooling plate 16 supported by an X-Y stage 5 by way of an insulator 17, the X-Y stage 5 being movable in X and Y directions by means not shown. The ion beam 3 is caused to scan the substrate 4 by a deflection electrode 2 (for the X and Y directions).

The secondary charged particles released from the surface of the substrate 4 are detected by a secondary charged particle detector 6. The detection is converted into brightness signals after amplification and processing by a signal amplifier-processor 14. The brightness signals, together with a scanning signal from a scanning controller 12, enter a display 15 on which an image of the secondary charged particles is displayed. The image of the secondary charged particles is used to locate the position on the substrate 4 where the metallic patterned film is to be made, and the area for the metallic patterned film is established by a scanning range setting unit 13. Upon receipt of a signal for the start of deposition, a valve 8 of a gas gun 7 is opened and the metal hexacarbonyl vapour is blown against the surface of the substrate 4. At this time, a gas source 9 is heated at a prescribed temperature by a heater (not shown), and the substrate 4 is kept cooled at a prescribed temperature not exceeding room temperature and preferably in the range + 25 to -50°C by the cooling plate 16 connected to a cooler 19. Thus, the surface of the substrate 4 which has absorbed the metal hexacarbonyl vapour is irradiated with the converging beam 3 which is controlled by the scanning range setting unit 13 for controlling the scanning range and scanning frequency. In the area irradiated with the converging ion beam 3, the metal hexacarbonyl vapour is decomposed with the result that CO gas is dissipated into the vacuum and metal is deposited on the surface of the substrate. When the scanning of the converging ion beam 3 is repeated while the metal hexacarbonyl vapour is blown continuously, there is formed a metallic patterned film having a thickness proportional to the number of scans effected.

As described above, the source gas for film formation is metal hexacarbonyl vapour instead of the conventional metal halide vapour. The metal hexacarbonyl vapour can be effectively absorbed by the surface of the substrate at a temperature slightly lower than room temperature, without being cooled to the liquefied nitrogen temperature. This leads to faster film growth and the formation of a film superior in conductivity and film adhesion. In an example in which the source gas is W(CO)₆ and the converging ion beam is of Ga ions, the resulting film has a specific resistance of about 10⁻⁴ to 10⁻⁵ Ω ·cm and submicrometer lines can be obtained. The film is composed mainly of W, and it contains very little oxygen joined to Ga and C. In addition, the film has sufficiently high hardness and adhesion. Therefore, the film formed by the method of this invention is suitable for the additional wiring of a semiconductor device and for the repair of a defective metallic pattern on an X-ray mask. For the repair of an X-ray mask, the converging ion beam is desirably of heavy metal ions (such as Au ions, Bi ions, and Pb ions) and the source gas is desirably W(CO)₆ so that there is formed a film having a greater coefficient of X-ray absorption.

## Claims

1. A method of forming a film on a substrate (4) comprising: directing a metal hexacarbonyl vapour onto a surface of the substrate (4) and irradiating said surface with a beam (3), said surface being maintained at a temperature not substantially exceeding 25°C, whereby a metal film is formed on said surface, characterised in that the beam is an ion beam consisting of Ga ions, Au ions, Bi ions, or Pb ions.

2. A method as claimed in claim 1 characterised in that the metal hexacarbonyl vapour is a vapour of W(CO)₆, Mo(CO)₆, or Cr(CO)₆.

3. A method as claimed in claim 1 or 2 characterised by scanning the ion beam (3) over the said surface a predetermined number of times.

4. A method as claimed in any preceding claim characterised in that the ion beam is derived from a fused metal ion source.

5. An apparatus for forming a metal film on a substrate (4) according to the method of claim 1 comprising: a support (5,16,17) for supporting a substrate (4); material directing means (7-9) for directing metal hexacarbonyl vapour onto a surface of said substrate (4) mounted on said support (5,16,17); irradiating means (1) for irradiating said surface with ainon beam (3) consisting of Ga ions, Au ions, Bi ions, or Pb ions; cooling means being provided for maintaining said surface at a temperature not substantially exceeding 25°C.

6. Apparatus as claimed in claim 5 characterised in that the irradiating means (1) comprises an ion beam generator (1) having a fused metal ion source (30) from which the ion beam (3) is drawn out.

7. Apparatus as claimed in claim 6 characterised in that a focusing lens system (34) is provided to converge the ion beam (3) which has been drawn out from the ion source (30).

8. Apparatus as claimed in any of claims 5-7 characterised in that there is a blanking electrode (35) which is operable to permit and prevent the ion beam (3) from being directed onto the said surface.

9. Apparatus as claimed in any of claims 5-8 characterised in that scanning means (2,12) are provided for deflecting the ion beam (3) so as to scan it over a predetermined portion of the substrate (4).

10. Apparatus as claimed in any of claims 5-9 characterised in that the said support (5,16,17) comprises an X-Y stage (5) for moving the substrate (4) in X and Y directions.

11. Apparatus as claimed in any of claims 5-10 characterised in that the material directing means (7-9) comprises a gas source (9) to hold and heat vapourisable material, and a gas gun (7) to blow gas from the gas source (9) onto the said surface.

12. Apparatus as claimed in any of claims 5-11 characterised by a detector (6) arranged to detect secondary charged particles generated by the irradiation of the said surface by the ion beam (3).

## Patentansprüche

1. Verfahren zum Bilden eines Films auf einem Substrat (4) umfassend: Leiten von Metallhexacarbonyldampf auf eine Oberfläche des Substrats (4) und Bestrahlen der Oberfläche mit einem Strahl (3), wobei die Oberfläche auf einer Temperatur gehalten wird, welche 25°C nicht wesentlich überschreitet, wodurch ein Metallfilm auf der Oberfläche erzeugt wird,
dadurch gekennzeichnet, daß
der Strahl ein aus Ga-Ionen, Au-Ionen, Bi-Ionen oder Pb-Ionen bestehender Ionenstrahl ist.

2. Verfahren nach Anspruch 1,
dadurch gekennzeichnet, daß
der Metallhexacarbonyldampf ein Dampf aus W(CO)₆, Mo(CO)₆ oder Cr(CO)₆ ist.

3. Verfahren nach Anspruch 1 oder 2,
dadurch gekennzeichnet, daß
die Oberfläche von dem Ionenstrahl (3) abgetastet wird, wobei die Anzahl der Abtastungen vorbestimmt ist.

4. Verfahren nach einem der vorhergehenden Ansprüche,
dadurch gekennzeichnet, daß
der Ionenstrahl von einer Ionenquelle mit geschmolzenem Metall entnommen ist.

5. Vorrichtung zum Bilden eines Metallfilms auf einem Substrat (4), gemäß dem Verfahren von Anspruch 1, umfassend: einen Träger (5, 16, 17) zum Tragen eines Substrats (4); Material-Leitmittel (7 - 9) zum Leiten von Metallhexacarbonyldampf auf eine Oberfläche des auf dem Träger (5, 16, 17) angebrachten Substrats (4);
Bestrahlungsmittel (1) zum Bestrahlen der Oberfläche mit einem aus Ga-Ionen, Au-Ionen, Bi-Ionen oder Pb-Ionen bestehenden Ionenstrahl (3);
wobei Kühlmittel vorgesehen sind, um die Oberfläche auf einer Temperatur zu halten, welche 25°C nicht wesentlich überschreitet.

6. Vorrichtung nach Anspruch 5,
dadurch gekennzeichnet, daß
das Bestrahlungsmittel (1) einen Ionenstrahlgenerator (1) mit einer Ionenquelle (30) mit geschmolzenem Metall umfaßt, aus welcher der Ionenstrahl (3) gezogen wird.

7. Vorrichtung nach Anspruch 6,
dadurch gekennzeichnet, daß
ein fokussierendes Linsensystem (34) zum Konvergieren des aus der Ionenquelle (30) gezogenen Ionenstrahls (3) vorgesehen ist.

8. Vorrichtung nach einem der Ansprüche 5 bis 7,
dadurch gekennzeichnet, daß
eine Ausblendelektrode (35) vorgesehen ist, welche zum Ermöglichen und zum Verhindern, daß der Ionenstrahl (3) auf die Oberfläche geleitet wird, betreibbar ist.

9. Vorrichtung nach einem der Ansprüchen 5 bis 8,
dadurch gekennzeichnet, daß
Abtastmittel (2, 12) zum Ablenken des Ionenstrahls (3) vorgesehen sind, um mit diesem einen vorbestimmten Bereich des Substrats (4) abzutasten.

10. Vorrichtung nach einem der Ansprüche 5 bis 9,
dadurch gekennzeichnet, daß
der Träger (5, 16, 17) eine X-Y Plattform (5) zum Bewegen des Substrats (4) in X und Y Richtung umfaßt.

11. Vorrichtung nach einem der Ansprüche 5 bis 10,
dadurch gekennzeichnet, daß
das Material-Leitmittel (7 - 9) eine Gasquelle (9) umfaßt, um verdampfbares Material zu halten und zu erwärmen, und eine Gaskanone (7), um Gas aus der Gasquelle (9) auf die Oberfläche zu blasen.

12. Vorrichtung nach einem der Ansprüche 5 bis 11,
gekennzeichnet durch
einen zum Erfassen von durch die Bestrahlung der Oberfläche mit dem Ionenstrahl (3) erzeugten, sekundären, geladenen Teilchen angeordneten Detektor (6).

## Revendications

1. Procédé de formation d'un film sur un substrat (4), qui consiste : à diriger de la vapeur de métal hexacarbonyle sur une surface du substrat (4) et à exposer cette surface à un faisceau (3), la surface étant maintenue à une température qui ne dépasse pas sensiblement 25°C de manière à former un film métallique sur la surface, caractérisé en ce que le faisceau est un faisceau ionique consistant en ions Ga, en ions Au, en ions Bi ou en ions Pb.

2. Procédé suivant la revendication 1, caractérisé en ce que la vapeur de métal hexacarbonyle est une vapeur de W(CO)₆, de Mo(CO)₆ ou de Cr(CO)₆.

3. Procédé suivant la revendication 1 ou 2, caractérisé en ce qu'il consiste à balayer la surface par le faisceau (3) d'ions un nombre de fois déterminé à l'avance.

4. Procédé suivant l'une quelconque des revendications précédentes, caractérisé en ce que le faisceau d'ions provient d'une source fondue d'ions métalliques.

5. Dispositif pour former un fil métallique sur un substrat (4) par le procédé de la revendication 1, comprenant : un support (5,16,17) destiné à supporter un substrat (4); des moyens (7 à 9) destinés à diriger de la vapeur de métal hexacarbonyle sur une surface du substrat (4) monté sur le support (5,16,17), des moyens (1) d'exposition de la surface à un faisceau (3) d'ions consistant en ions Ga, en ions Au, en ions Bi ou en ions Pb, des moyens de refroidissement étant prévus pour maintenir la surface à une température ne dépassant pas sensiblement 25°C.

6. Dispositif selon la revendication 5, caractérisé en ce que les moyens (1) d'exposition comprennent un générateur (1) de faisceaux d'ions ayant une source (30) fondue d'ions métalliques dont provient le faisceau (3) d'ions.

7. Dispositif selon la revendication 6, caractérisé en ce qu'un système (34) de focalisation à lentilles est prévu pour faire converger le faisceau (3) d'ions qui provient de la source (30) d'ions.

8. Dispositif selon l'une quelconque des revendications 5 à 7, caractérisé en ce qu'il est prévu une électrode (35) d'arrêt, qui peut fonctionner de manière à permettre et à empêcher au faisceau (3) d'ions d'être dirigé sur la surface.

9. Dispositif selon l'une quelconque des revendications 5 à 8, caractérisé en ce qu'il est prévu des moyens (2,12) de balayage pour dévier le faisceau (3) d'ions de manière à ce qu'il balaye une partie déterminée à l'avance du substrat (4).

10. Dispositif selon l'une quelconque des revendications 5 à 9, caractérisé en ce que le support (5, 16, 17) comprend une embase (5) permettant de déplacer le substrat (4) dans les directions X et Y.

11. Dispositif selon l'une quelconque des revendications 5 à 10, caractérisé en ce que les moyens (7 à 9) destinés à diriger la vapeur de métal hexacarbonyle comprennent une source (9) de gaz destinée à retenir et à chauffer de la matière susceptible d'être mise sous forme de vapeur et un canon (7) à gaz pour insuffler du gaz de la source (9) sur la surface.

12. Dispositif selon l'une quelconque des revendications 5 à 11, caractérisé par un détecteur (6) agencé de manière à détecter des particules secondaires chargées engendrées par l'exposition de la surface au faisceau (3) d'ions.
